(19) Europäisches Patentamt / European Patent Office / Office européen des brevets

(11) **EP 2 994 765 B1**

## (12) EUROPÄISCHE PATENTSCHRIFT

(45) Veröffentlichungstag und Bekanntmachung des Hinweises auf die Patenterteilung:
**28.11.2018 Patentblatt 2018/48**

(51) Int Cl.:
*G01R 31/02* *(2006.01)*    *G01R 31/08* *(2006.01)*
*H02H 3/16* *(2006.01)*    *H02H 7/26* *(2006.01)*

(21) Anmeldenummer: **13729633.1**

(22) Anmeldetag: **05.06.2013**

(86) Internationale Anmeldenummer:
**PCT/EP2013/061545**

(87) Internationale Veröffentlichungsnummer:
**WO 2014/194941 (11.12.2014 Gazette 2014/50)**

(54) **ERKENNUNG VON ERDFEHLERN IN ENERGIEVERSORGUNGSNETZEN MIT KOMPENSIERTEM STERNPUNKT**

DETECTION OF GROUND FAULTS IN ENERGY SUPPLY NETWORKS WITH A COMPENSATED STAR POINT

DÉTECTION DE DÉFAUTS À LA TERRE DANS DES RÉSEAUX DE DISTRIBUTION D'ÉNERGIE À POINT NEUTRE COMPENSÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**16.03.2016 Patentblatt 2016/11**

(73) Patentinhaber: **Siemens Aktiengesellschaft
80333 München (DE)**

(72) Erfinder:
• **LUKOWICZ, Miroslaw
PL-51-649 Wrozlaw (PL)**
• **MICHALIK, Marek
PL-54-211 Wrozlaw (PL)**
• **REBIZANT, Waldemar
PL-53/678 Wrozlaw (PL)**
• **KEREIT, Matthias
12159 Berlin (DE)**

(56) Entgegenhaltungen:
EP-A2- 1 089 081    EP-A2- 1 953 890
WO-A1-2004/003578    WO-A1-2013/060382
WO-A2-02/15355    DE-A1- 10 307 972
DE-A1-102004 008 994    DE-B3- 10 302 451
US-A1- 2011 109 465

• KAZIMIERZ MUSIEROWICZ ET AL: "A fuzzy logicbased algorithm for discrimination of damaged line during intermittent earth faults", POWER TECH, 2005 IEEE RUSSIA, IEEE, PISCATAWAY, NJ, USA, 27. Juni 2005 (2005-06-27), Seiten 1-5, XP031254667, ISBN: 978-5-93208-034-4

• LIU J H ET AL: "Application of fractal theory in detecting low current faults of power distribution system in coal mines", MINING SCIENCE AND TECHNOLOGY (CHINA), ELSEVIER, AMSTERDAM, NL, Bd. 19, Nr. 3, 1. Mai 2009 (2009-05-01), Seiten 321-325, XP026194964, ISSN: 1674-5264, DOI: 10.1016/S1674-5264(09)60060-0 [gefunden am 2009-05-01]

• XIANGJUN ZENG ET AL: "Some ground fault protection schemes implemented on FTU for industrial power systems", INDUSTRY APPLICATIONS CONFERENCE, 2004. 39TH IAS ANNUAL MEETING. CONFE RENCE RECORD OF THE 2004 IEEE SEATTLE, WA, USA 3-7 OCT. 2004, PISCATAWAY, NJ, USA,IEEE, Bd. 4, 3. Oktober 2004 (2004-10-03), Seiten 2453-2457, XP010735458, DOI: 10.1109/IAS.2004.1348819 ISBN: 978-0-7803-8486-6

**(Forts. nächste Seite)**

- ZHANG LINLI ET AL: "Fault location method based on zero sequence admittance measurement in non-effectively earthed system", INNOVATIVE SMART GRID TECHNOLOGIES - ASIA (ISGT ASIA), 2012 IEEE, IEEE, 21. Mai 2012 (2012-05-21), Seiten 1-4, XP032237400, DOI: 10.1109/ISGT-ASIA.2012.6303095 ISBN: 978-1-4673-1221-9
- XIANGJUN ZENG ET AL: "Ground-Fault Feeder Detection With Fault-Current and Fault-Resistance Measurement in Mine Power Systems", IEEE TRANSACTIONS ON INDUSTRY APPLICATIONS, IEEE SERVICE CENTER, PISCATAWAY, NJ, US, Bd. 44, Nr. 2, 1. März 2008 (2008-03-01), Seiten 424-429, XP011206351, ISSN: 0093-9994
- ZHANG ET AL: "Detection and Location of Ground Faults Using a Discernible Signal", TRANSMISSION AND DISTRIBUTION CONFERENCE AND EXHIBITION: ASIA AND PACIFIC, 2005 IEEE/PES DALIAN, CHINA 15-18 AUG. 2005, PISCATAWAY, NJ, USA,IEEE, PISCATAWAY, NJ, USA, 1. Januar 2005 (2005-01-01), Seiten 1-4, XP031034921, ISBN: 978-0-7803-9114-7
- XIANGNING LIN ET AL: "A Novel Adaptive Protective Scheme For the Single-Phase Earth Fault of the Non-Effectively Grounded Power Systems", POWER SYSTEM TECHNOLOGY, 2006. POWERCON 2006. INTERNATIONAL CONFERENCE ON, IEEE, PI, 1. Oktober 2006 (2006-10-01), Seiten 1-4, XP031053454, ISBN: 978-1-4244-0110-9
- SCHAEFER H-D ET AL: "ERHOEHUNG DER VERLAGERUNGS-SPANNUNG IN MITTELSPANNUNGS-KABELNETZEN MIT ERDSCHLUSSKOMPENSATION", ELEKTRIZITAETSWIRTSCHAFT, VEREINIGUNG DEUTSCHER ELEKTRIZITAETZSWERKE, FRA, DE, Bd. 93, Nr. 21, 4. Oktober 1994 (1994-10-04), XP000469358, ISSN: 0013-5496

**Beschreibung**

Die Erfindung betrifft ein Verfahren zum Erkennen eines Erdfehlers in einem elektrischen Energieversorgungsnetz mit kompensiertem Sternpunkt, bei dem an zumindest einer Messstelle des Energieversorgungsnetzes Messwerte erfasst werden, die einen Zustand des Energieversorgungsnetzes charakterisieren, aus den Messwerten eine Nullsystemspannung und eine Admittanzgröße ermittelt werden und die Nullsystemspannung und die Admittanzgröße zur Erkennung des Erdfehlers in dem Energieversorgungsnetz herangezogen werden. Die Erfindung betrifft außerdem ein entsprechendes elektrisches Schutzgerät sowie ein Schutzsystem.

Elektrische Erdfehler, also fehlerhafte niederohmige elektrische Verbindungen eines Phasenleiters mit Erde, bilden den Großteil der Fehler in dreiphasigen elektrischen Energieversorgungsnetzen. Sie werden beispielsweise durch Kontakt mit an die Leitung herangewachsenen Bäumen oder durch Blitzschlag hervorgerufen oder beruhen auf einer Zerstörung der Leitung mit anschließender Erdberührung. Teilweise handelt es sich dabei um dauerhaft anstehende Erdfehler, teilweise auch um kurzzeitig auftretende Fehler, sogenannte "Erdschlusswischer".

Elektrische Energieversorgungsnetze können mit unterschiedlichen Erdungsvarianten bezüglich ihres Sternpunktes betrieben werden. Energieversorgungsnetze mit geerdetem Sternpunkt, die eine wirksame elektrische Verbindung zwischen ihrem Sternpunkt und Erde aufweisen, gewährleisten eine hohe Symmetrie zwischen den einzelnen Phasenströmen und -spannungen, jedoch fließen bei dieser Variante im Falle eines einzelnen Erdfehlers aufgrund der elektrisch geschlossenen Leiter-Erde-Schleife hohe Fehlerströme, die sofort zu einer Abschaltung der fehlerbehafteten Leitung führen müssen. Daher werden Energieversorgungsnetze in bestimmten Spannungsebenen (z.B. im Bereich der Mittelspannung zwischen 6kV und 110kV) häufig mit isoliertem oder kompensiertem ("gelöschtem") Sternpunkt betrieben. Bei einem isolierten Sternpunkt besteht keine wirksame elektrische Verbindung des Sternpunktes mit Erde, während bei einem kompensierten Sternpunkt eine Induktivität, z.B. eine sogenannte "Petersenspule", in der Verbindung zwischen Sternpunkt und Erde angeordnet ist. Einpolige Erdfehler führen in solchen Netzen nicht zu einem dauerhaften Kurzschlussstrom. In der Regel erfolgt daher in isolierten oder kompensierten Energieversorgungsnetzen bei einfachen Erdfehlern keine Schutzauslösung, da das Energieversorgungsnetz mit einem einfachen Erdfehler weiterbetrieben werden kann. Der Netzbetreiber ist jedoch verpflichtet, den fehlerhaften Leitungsabschnitt zu bestimmen und den Schaden schnellstmöglich zu beheben.

Ein Verfahren der eingangs genannten Art ist z.B. aus der internationalen Patentanmeldung WO 01/22104 A1 bekannt. Bei dem bekannten Verfahren wird die Erkennung eines Erdfehlers anhand einer Nullsystemspannung und einer Admittanzgröße in Form einer Phase-Erde-Admittanz sowie einer einen Grad einer Unsymmetrie angebenden Symmetriekenngröße durchgeführt.

Weitere Verfahren zur Erkennung von Erdfehlern in Energieversorgungsnetzen sind beispielsweise aus der WO 2004/003578 A1 oder dem Aufsatz von K. Musierowicz, J. Lorenc, Z. Marcinkowski, A. Kwapisz "A Fuzzy Logic-Based Algorithm for Dicrimination of Damaged Line During Intermittent Earth Faults"; Power Tech, 2005 IEEE Russia, IEEE Piscatawy, NJ, US, 27.06.2005, Seiten 1-5 bekannt.

Im Zusammenhang mit kompensierten Energieversorgungsnetzen ist es zudem bekannt, zur besseren Erkennung von Erdfehlern eine Erdungseinrichtung, z.B. eine sogenannte "KNOSPE-Schaltung" (KNOSPE = kurze niederohmige Sternpunkt-Erdung), im Englischen Sprachgebrauch auch als "ANCF-Verfahren" (ANCF = Active Neutral Current Forcing) bezeichnet, einzusetzen. Bei diesem Verfahren wird der Sternpunkt des Energieversorgungsnetzes bei Verdacht auf einen anstehenden Erdfehler kurzzeitig über einen ohmschen Widerstand geerdet. Nach dem Erden fließt ein Kurzschlussstrom und die Leitungsschutzgeräte, wie z.B. Distanzschutzgeräte, können aufgrund des signifikanten Fehlerstromes Anregesignale oder Auskommandos bilden.

Jedoch kommt es bei Verwendung solcher Erdungseinrichtungen, insbesondere bei sehr hochohmigen Erdfehlern, z.B. mit Fehlerwiderständen oberhalb von 2kQ, aufgrund der geringen fließenden Fehlerströme zu fehlerhaften Entscheidungen, so dass anstehende Erdfehler nicht erkannt werden.

Der Erfindung liegt daher die Aufgabe zugrunde, eine vergleichsweise einfache Möglichkeit zur Erkennung eines anstehenden Erdfehlers anzugeben, mit der auch hochohmige Erdfehler zuverlässig erkannt werden.

Hinsichtlich des Verfahrens wird die genannte Aufgabe durch ein Verfahren der eingangs angegebenen Art gelöst, bei dem beim Vorliegen von Messwerten, die auf einen Erdfehler in dem Energieversorgungsnetz hindeuten, der Sternpunkt des Energieversorgungsnetzes durch Zuschalten einer Erdungseinrichtung temporär mit Erde verbunden wird, und ein Erdfehler in dem Energieversorgungsnetz erkannt wird, wenn während der zugeschalteten Erdungseinrichtung sowohl die Nullsystemspannung einen vorgegebenen Nullsystemspannungs-Schwellenwert als auch die Admittanzgröße einen vorgegebenen Admittanz-Schwellenwert überschreiten, wobei das Zuschalten der Erdungseinrichtung eine Reduzierung des Nullsystemspannungs-Schwellenwertes bewirkt.

Der Erfindung liegt die Erkenntnis zugrunde, dass mögliche Fehlentscheidungen bei der Erkennung hochohmiger Erdfehler in kompensierten Energieversorgungsnetzen unter gleichzeitiger Nutzung einer Erdungseinrichtung, wie z.B. der KNOSPE-Automatik, häufig darauf zurückzuführen sind, dass bei aktivierter Erdungseinrichtung, d.h. bei der temporären Erdung des Sternpunkts des Energieversorgungsnetzes, die Nullsystemspannung deutlich absinkt. Mit steigendem Fehlerwiderstand erhöht sich dieser Effekt. Daher ist erfindungsgemäß vorgesehen, den Nullsystemspannungs-Schwellenwert adaptiv an den Status der Erdungseinrichtung anzupassen, indem der Nullsystemspannungs-Schwellenwert bei aktivierter Erdungseinrichtung abgesenkt wird. Hierdurch kann auch bei vergleichsweise deutlichem Einbrechen der Nullsystemspannung immer noch eine zuverlässige Fehlererkennung erfolgen, wenn das verwendete Admittanzkriterium einen Erdfehler anzeigt.

Eine vorteilhafte Weiterbildung des erfindungsgemäßen Verfahrens sieht vor, dass die Reduzierung des Nullsystemspannungs-Schwellenwertes nach Ablauf einer vorgegebenen Verzögerungszeit zurückgenommen wird.

Die Verzögerungszeit kann hierbei fest eingestellt sein und z.B. einem Aktivierungszyklus der Erdungseinrichtung entsprechen, d.h. derjenigen Zeitdauer, die die Erdungseinrichtung üblicherweise in aktivierter Stellung verharrt und den Sternpunkt des Energieversorgungsnetzes mit Erde verbindet. Die Verzögerungszeit kann hierbei aber auch derart eingestellt sein, dass sie nach erfolgter Entscheidung über das Vorliegen eines Erdfehlers, d.h. der Entscheidung, ob ein Erdfehler vorliegt oder nicht, beendet wird. Im letztgenannten Fall kann die Dauer der Verzögerungszeit unterschiedlich sein, da ihr Ende jeweils durch die Entscheidung über den Erdfehler getriggert wird. Auch eine Kombination beider Alternativen ist denkbar, beispielsweise in der Art, dass die Verzögerungszeit durch die Entscheidung über den Fehler beendet werden kann, allerdings maximal eine vorgegebene Zeitdauer annimmt.

Eine weiter vorteilhafte Weiterbildung des erfindungsgemäßen Verfahrens ist dadurch gegeben, dass die Reduzierung des Nullsystemspannungs-Schwellenwertes gemäß der Gleichung

$$U'_{0P} = k_R \cdot U_{0P}$$

erfolgt, mit

$U'_{0P}$: Nullspanungs-Schwellenwert nach der Reduzierung;
$U_{0P}$: Nullspannungs-Schwellenwert; und
$k_R$: einstellbarer Reduzierungsfaktor.

Die Verwendung der oben genannten Beziehung erlaubt eine vergleichsweise einfache Einstellung der Reduktion des Nullsystemspannungs-Schwellenwertes, da der Betreiber eines Gerätes, mit dem das Verfahren durchgeführt wird, beispielsweise eines elektrischen Distanzschutzgerätes, zusätzlich zu dem ohnehin festzulegenden Nullsystemspannungs-Schwellenwert nur noch den Reduzierungsfaktor als Parameter in dem Gerät einstellen muss. Mögliche Werte des Reduzierungsfaktors liegen beispielsweise zwischen 0,5 und 1. Durch eine Einstellung des Reduzierungsfaktors auf den Wert 1 kann der Betreiber zudem auf einfache Weise das Verfahren der adaptiven Anpassung des Nullsystemspannungs-Schwellenwertes deaktivieren.

Konkret kann gemäß einer weiteren vorteilhaften Weiterbildung des erfindungsgemäßen Verfahrens außerdem vorgesehen sein, dass als Admittanzgröße eine Nullsystem-Admittanz oder der Realteil der Nullsystem-Admittanz, der sogenannte "Wirkleitwert" oder "Konduktanz", verwendet wird. Zudem sind auch andere Admittanzgrößen, beispielsweise Kombinationen aus Admittanz, Konduktanz und/oder Suszeptanz (Imaginärteil der Admittanz) als verwendete Admittanzgrößen einsetzbar.

Hinsichtlich der Aktivierung der Erdungseinrichtung kann gemäß einer weiteren vorteilhaften Ausführungsform des erfindungsgemäßen Verfahrens vorgesehen sein, dass zur Untersuchung, ob die Messwerte auf einen Erdfehler in dem Energieversorgungsnetz hindeuten, geprüft wird, ob die Nullsystemspannung einen erhöhten Wert annimmt.

Dies ist vorteilhaft, weil das Auftreten einer signifikanten Nullsystemspannung in kompensierten Energieversorgungsnetzen ein zuverlässiger Hinweis auf das Vorliegen eines Fehlers ist. Bei dieser Ausführungsform kann beispielsweise die Nullsystemspannung mit dem - nicht reduzierten - Nullsystemspannungs-Schwellenwert verglichen werden, um festzustellen, ob die Nullsystemspannung signifikant erhöht ist. Es ist jedoch auch denkbar, für die Entscheidung zur Aktivierung der Erdungseinrichtung einen separat festgelegten Schwellenwert für die Nullsystemspannung zu verwenden. Die Aktivierung der Erdungseinrichtung kann hierbei entweder durch eine eigenständige Steuereinrichtung erfolgen oder durch dasselbe Gerät, das auch das Verfahren zur Erdfehlererkennung mit adaptiver Anpassung des Nullsystemspannungs-Schwellenwertes durchführt, bewirkt werden.

Gemäß einer weiteren vorteilhaften Ausbildung des erfindungsgemäßen Verfahrens ist zudem vorgesehen, dass bei Erkennung eines Erdfehlers ein den Fehler angebendes Fehlersignal erzeugt wird.

Das Fehlersignal kann hierbei einerseits als Information für den Betreiber des Energieversorgungsnetzes dienen, um die von dem Erdfehler betroffene Leitung anzugeben. Wie eingangs erwähnt, kann die Leitung auch bei einem vorliegenden Erdfehler aufgrund der vergleichsweise geringen Fehlerströme vorübergehend weiterbetrieben werden, bis sich eine Gelegenheit zur Fehlerbehebung bietet. Jedoch muss der Erdfehler erkannt und einer Leitung zugeordnet werden.

Hinsichtlich des Fehlersignals kann jedoch gemäß einer vorteilhaften Weiterbildung des erfindungsgemäßen Verfahrens auch vorgesehen sein, dass das Fehlersignal ein Ausschalten einer Schalteinrichtung bewirkt.

Bei der Schalteinrichtung kann es sich z.B. um einen Leistungsschalter handeln, mit dem die von dem Erdfehler betroffene Leitung vom übrigen Energieversorgungsnetz abgetrennt werden kann.

Gemäß einer weiteren vorteilhaften Ausführungsform des erfindungsgemäßen Verfahrens kann zudem vorgesehen sein, dass das Verfahren für mehrere Leitungen in dem elektrischen Energieversorgungsnetz durchgeführt wird, wobei die Nullsystemspannung für das Energieversorgungsnetz insgesamt bestimmt wird und die Admittanzgröße für jede Leitung separat ermittelt wird, und diejenige Leitung als von dem Erdfehler betroffen erkannt wird, für die die Admittanzgröße den vorgegebenen Admittanz-Schwellenwert überschreitet.

Auf diese Weise lässt sich auch in Energieversorgungsnetzen mit mehreren Leitungen, beispielsweise in Mittelspannungsnetzen mit mehreren von einer Sammelschiene abgehenden Abzweigleitungen, zuverlässig die von dem Erdfehler betroffene Leitung erkennen, so dass eine Klärung des Fehlers ermöglicht wird, ohne das komplette Energieversorgungsnetz stromlos schalten zu müssen.

Die oben genannte Aufgabe wird auch durch ein elektrisches Schutzgerät zur Erkennung von Erdfehlern in Energieversorgungsnetzen mit kompensiertem Sternpunkt gelöst mit einer Messeinrichtung zur Erfassung von Messwerten, die einen Zustand des Energieversorgungsnetzes charakterisieren, und zur Ermittlung einer Nullsystemspannung und einer Admittanzgröße aus dem Messwerten und mit einer Fehlererkennungseinrichtung, die dazu eingerichtet ist, eine Erkennung eines Erdfehlers unter Heranziehung der Nullsystemspannung und der Admittanzgröße durchzuführen.

Erfindungsgemäß ist vorgesehen, dass das Schutzgerät dazu eingerichtet ist, mit einer Erdungseinrichtung zusammenzuwirken, die beim Vorliegen von Messwerten, die auf einen Erdfehler in dem Energieversorgungsnetz hindeuten, den Sternpunkt des Energieversorgungsnetzes mit Erde verbindet, und die Fehlererkennungseinrichtung dazu eingerichtet ist, einen Erdfehler in dem Energieversorgungsnetz zu erkennen, wenn während der zugeschalteten Erdungseinrichtung sowohl die Nullsystemspannung einen vorgegebenen Nullsystemspannungs-Schwellenwert als auch die Admittanzgröße einen vorgegebenen Admittanz-Schwellenwert überschreiten, wobei die Fehlererkennungseinrichtung zudem dazu eingerichtet ist, mit dem Zuschalten der Erdungseinrichtung eine Reduzierung des Nullsystemspannungs-Schwellenwertes vorzunehmen.

Hinsichtlich der Vorteile und möglichen vorteilhaften Weiterbildungen des elektrischen Schutzgerätes gelten die für das erfindungsgemäße Verfahren vorstehend gemachten Ausführungen in entsprechender Weise.

Außerdem wird die Aufgabe auch durch ein Schutzsystem zur Erkennung von Erdfehlern in Energieversorgungsnetzen mit kompensiertem Sternpunkt gelöst mit einer Erdungseinrichtung, die beim Vorliegen von einen Zustand des Energieversorgungsnetzes charakterisierenden Messwerten, die auf einen Erdfehler in dem Energieversorgungsnetz hindeuten, den Sternpunkt des Energieversorgungsnetzes mit Erde verbindet, und mindestens einem elektrischen Schutzgerät, das gemäß Anspruch 9 ausgebildet ist.

Die Erfindung wird nachfolgend anhand eines Ausführungsbeispiels näher erläutert. Hierzu zeigen

Figur 1          eine schematische Ansicht eines Teils eines elektrischen Energieversorgungsnetzes;

Figur 2          ein schematisches Verfahrensablauffließbild;

Figuren 3A und 3B      Kennlinien für die Bewertung einer Admittanzgröße zur Erkennung eines Erdfehlers in einem Energieversorgungsnetz;

Figur 4          ein Beispiel eines Verlaufs der Nullsystemspannung und einer Admittanzgröße ohne adaptive Anpassung eines Nullsystemspannungs-Schwellenwertes; und

Figur 5          ein Beispiel eines Verlaufs der Nullsystemspannung und einer Admittanzgröße mit adaptiver Anpassung des Nullsystemspannungs-Schwellenwertes.

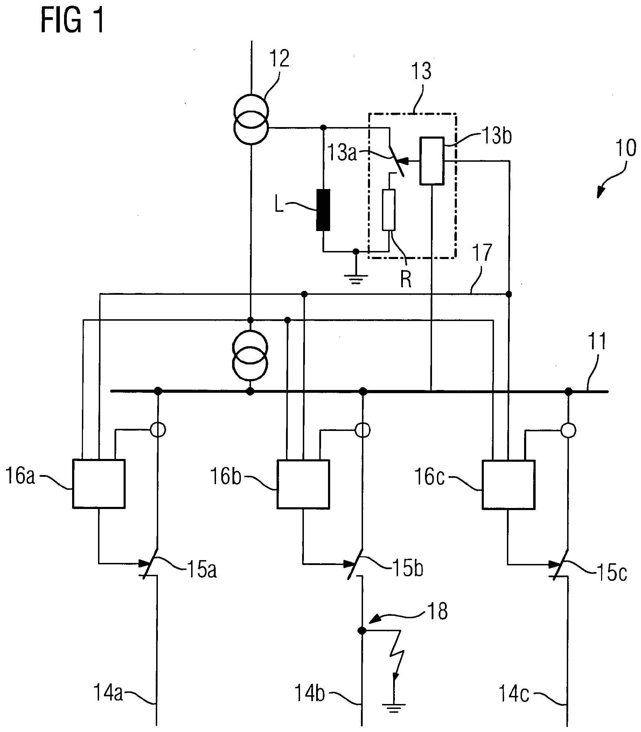

In Figur 1 ist in schematischer Darstellung ein Teil eines elektrischen Energieversorgungsnetzes 10 gezeigt, bei dem es sich beispielhaft um ein Mittelspannungs-Energieversorgungsnetz handelt. Eine Sammelschiene 11 wird durch einen Transformator 12 gespeist, der Sternpunkt der Sekundärseite des Transformators 12 ist über eine Induktivität L, beispielsweise eine sogenannte "Petersenspule", mit Erde verbunden, so dass das Energieversorgungsnetz 10 als kompensiertes Netz betrieben wird. Parallel zur Induktivität L ist ein Ohmscher Widerstand R einer Erdungseinrichtung 13 angeordnet, über den der Sternpunkt des Energieversorgungsnetzes 10 bei Bedarf direkt mit Erde verbunden werden kann. Dazu weist die Erdungseinrichtung 13 eine Steuereinrichtung 13a auf, die mit einer Schalteinrichtung 13b zusammenwirkt, um den Stromfluss durch den ohmschen Widerstand R ein- oder auszuschalten. Auf die genaue Funktionsweise der Erdungseinrichtung 13 wird später näher eingegangen.

Von der Sammelschiene 11 gehen drei Abzweigleitungen 14a-c ab, die beispielsweise zu in Figur 1 nicht gezeigten elektrischen Lasten führen können. Die Abzweigleitungen 14a-c sind über Schalteinrichtungen 15a-c mit der Sammelschiene 11 verbunden. Außerdem sind am Eingang der Abzweigleitungen 14a-c jeweils elektrische Schutzgeräte 16a-c angeordnet, die mittels einer in Figur 1 nicht explizit dargestellten Messeinrichtung über in Figur 1 lediglich schematisch angedeutete Strom- und Spannungswandler Strom- und Spannungsmesswerte erfassen. Dabei werden die Spannungsmesswerte an der Sammelschiene für das Energieversorgungsnetz 10 insgesamt erfasst, während die Strommesswerte für jede Abzweigleitung 14a-c separat erfasst werden.

Die Schutzgeräte 16a-c sind außerdem mit der Erdungseinrichtung 13 verbunden, um den Zustand eines Statuskontaktes der Erdungseinrichtung 13 an die Schutzgeräte 16a-c zu melden. Dies kann wie in Figur 1 angedeutet beispielsweise über einen Kommunikationsbus 17 erfolgen, über den der Zustand der Erdungseinrichtung 13 in Form eines Telegramms, beispielsweise eines GOOSE-Telegramms (GOOSE - Generic Object Oriented Substation Event) gemäß dem Standard IEC 61850 zur Kommunikation in Schaltanlagen, übermittelt wird.

Die Schutzgeräte dienen dazu, die Abzweigleitungen 14a-c des Energieversorgungsnetzes 10 auf Erdfehler zu überwachen. Beispielhaft ist in der Figur 1 ein Erdfehler bezüglich der Abzweigleitung 14b an der Stelle 18 gezeigt. Zur Erdfehlererkennung nehmen die Schutzgeräte 16a-c mit ihren Messeinrichtungen Messwerte auf und ermitteln aus diesen eine Nullsystemspannung $U_0$ und eine Admittanzgröße, beispielsweise eine Nullsystem-Admittanz $Y_0$ oder eine Nullsystem-Konduktanz $G_0$. Anhand der Nullsystemspannung $U_0$ und der Admittanzgröße überprüfen die Schutzgeräte 16a-c mittels einer Fehlererkennungseinrichtung, ob auf ihrer jeweiligen Abzweigleitung 14a-c ein Erdfehler vorliegt. Das Vorliegen eines Erdfehlers wird hierbei genau dann erkannt, wenn sowohl die Nullsystemspannung als auch die Admittanzgröße oberhalb jeweiliger Schwellenwerte liegen. Dabei sollen auch hochohmige Erdfehler mit Fehlerwiderständen oberhalb von 2kΩ zuverlässig erkannt werden. Um dies zu gewährleisten, berücksichtigen die Schutzgeräte 16a-c für die Erdfehlererkennung zusätzlich eine Information über den aktuellen Zustand der Erdungseinrichtung 13, da bei aktivierter Erdungseinrichtung 13, d.h. bei geschlossener Schalteinrichtung 13a, die Nullsystemspannung $U_0$ in dem Energieversorgungsnetz 10 im Vergleich zur Erdungssituation über die Induktivität L trotz anstehendem Erdfehler signifikant absinkt. Um diesen Effekt zu berücksichtigen, senken die Schutzgeräte 16a-c bei aktivierter Erdungseinrichtung 13 den zur Bewertung der Nullsystemspannung $U_0$ verwendeten Nullsystemspannungs-Schwellenwert $U_{0P}$ zeitweise ab. Dies erfolgt beispielsweise gemäß der folgenden Gleichung:

$$U'_{0P} = k_R \cdot U_{0P} \, , \qquad\qquad (1)$$

wobei $U_{0P}$ der normalerweise verwendete Nullspannungs-Schwellenwert, $U'_{0P}$ der Nullspanungs-Schwellenwert nach der Reduzierung und $k_R$ ein einstellbarer Reduzierungsfaktor ist.

Um eine verlässliche Aussage über das Vorliegen eines Erdfehlers zu treffen und um bei selbstverlöschenden Erdfehlern (z.B. verursacht durch eine kurzzeitige Berührung einer Leitung mit einem Ast eines Baumes) nicht unnötig auf einen Erdfehler zu erkennen, wird für die Überprüfung der Nullsystemspannung $U_0$ und der Admittanzgröße üblicherweise eine Verzögerungszeit $T_{TD}$ vorgesehen. Nur wenn die betrachteten Kriterien auch nach Ablauf der Verzögerungszeit $T_{TD}$ das Vorliegen eines Erdfehlers angeben, wird definitiv auf einen Erdfehler erkannt.

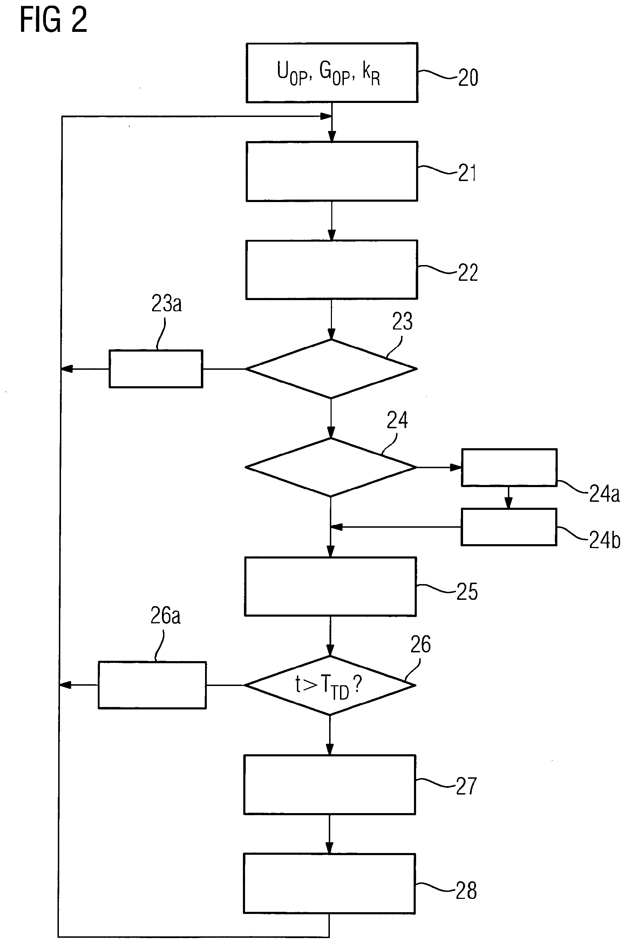

Die Funktionsweise bei der Überwachung wird nachfolgend eingehender unter Hinzunahme von Figur 2 erläutert. Hierzu zeigt Figur 2 ein Verfahrensablaufschema mit den einzelnen zur Erdfehlererkennung durchgeführten Schritten.

In einem ersten Schritt 20 wird das Verfahren einmalig initialisiert, d.h. es werden von einem Betreiber der Schutzgeräte notwendige Einstellungen als Parameter festgelegt, darunter auch die Werte für den Nullsystemspannungs-Schwellenwert $U_{0P}$ und den Admittanz-Schwellenwert $G_{0P}$. Beispielhaft wird hierbei davon ausgegangen, dass es sich bei der betrachteten Admittanzgröße um den Nullsystem-Wirkleitwert bzw. die Nullsystem-Konduktanz $G_0$ handelt. Außerdem wird in Schritt 20 der Reduzierungsfaktor $k_R$ festgelegt, der denjenigen Faktor angibt, um den der Nullsystemspannungs-Schwellenwert bei aktivierter Erdungseinrichtung 13 abgesenkt werden soll. Der Reduzierungsfaktor $k_R$ kann beispielsweise zwischen 0,5 und 1 gewählt werden. Geräteintern wird bei der Initialisierungsphase zudem der reduzierte Nullsystemspannungs-Schwellenwert $U'_{0P}$ auf denselben Wert eingestellt wie der Nullsystemspannungs-Schwellenwert $U_{0P}$.

Wie Gleichung (1) entnommen werden kann, ist es für den Betreiber der Schutzgeräte 16a-c in einfacher Weise möglich, durch Auswahl einer Einstellung von 1 als Wert für den Reduzierungsfaktor $k_R$ das Verfahren zur adaptiven Anpassung des Nullsystemspannungs-Schwellenwertes $U_{0P}$ faktisch zu deaktivieren, da in diesem Fall der reduzierte Schwellenwert $U'_{0P}$ dem "normalen" Schwellenwert $U_{0P}$ entspricht.

Mit Schritt 21 beginnt die eigentliche Überwachungsphase. Dabei werden von den Schutzgeräten 16a-c mittels integrierter Messeinrichtungen Messwerte aufgenommen, die einen Zustand des elektrischen Energieversorgungsnetzes charakterisieren. Bei den Messwerten kann es sich beispielsweise um Phasenströme und -spannungen und/oder Nullsystemströme und -spannungen handeln. Die Messwerte können vorzugsweise als sogenannte Phasormesswerte erfasst werden, also Zeigermesswerte in der komplexen Zahlenebene, die eine Information sowohl zur Amplitude als auch zum Phasenwinkel der betrachteten Messgröße umfassen. Die Bildung solcher Phasormesswerte kann in dem jeweiligen Schutzgerät 16a-c oder in einer vorgelagerten Messeinrichtung, beispielsweise einer sogenannten "Phasor Measurement Unit" (PMU) erfolgen.

In einem folgenden Schritt 22 werden aus den Messwerten die zur Erkennung eines Erdfehlers benötigten Größen, also eine Nullsystemspannung $U_0$ und eine Admittanzgröße in Form der Nullsystem-Konduktanz $G_0$ gebildet. Dies kann beispielsweise mit einem speziell an die Messwertbearbeitung angepassten digitalen Signalprozessor des jeweiligen Schutzgerätes 16a-c erfolgen.

In Schritt 23 wird nachfolgend der Zustand der Erdungseinrichtung 13 überprüft. Konkret wird hierbei geprüft, ob sich die Erdungseinrichtung 13 in einem aktivierten (Schalteinrichtung 13a geschlossen) oder einem nicht aktivierten (Schalteinrichtung 13a geöffnet) Zustand befindet. Dieser kann beispielsweise über einen Statuskontakt der Erdungseinrichtung 13 angegeben und über den Kommunikationsbus 17 an die Schutzgeräte 16a-c übermittelt werden.

Die Erdungseinrichtung 13 wird bei Messwerten, die auf einen Erdfehler in dem Energieversorgungsnetz 10 hindeuten, durch die Steuereinrichtung 13b aktiviert. Dazu werden der Steuereinrichtung 13b beispielsweise an der Sammelschiene des Energieversorgungsnetzes aufgenommene Spannungsmesswerte zugeführt und von dieser ausgewertet. Die Auswertung kann hierbei eine Ermittlung einer Nullsystemspannung $U_0$ umfassen, wobei bei einer erhöhten Nullsystemspannung $U_0$ auf einen Erdfehler in dem Energieversorgungsnetz 10 geschlossen werden kann. Die Entscheidung über die Aktivierung der Erdungseinrichtung 13 kann abweichend von der Darstellung in Figur 1 auch durch eines der Schutzgeräte 16a-c getroffen werden. Der Vergleichswert für die Nullsystemspannung $U_0$ bezüglich der Aktivierung der Erdungseinrichtung 13 kann beispielsweise dem Nullsystemspannungs-Schwellenwert $U_{0P}$ entsprechend, aber auch auf einen anderen geeigneten Wert festgelegt werden. Die Entscheidung über die Aktivierung der Erdungseinrichtung 13 ist in dem Ablaufschema gemäß Figur 2 nicht explizit dargestellt.

Sollte die Prüfung im Schritt 23 ergeben, dass die Erdungseinrichtung 13 nicht aktiviert ist, so startet das Verfahren bei Schritt 21 erneut, weil das Energieversorgungsnetz in diesem Fall aufgrund der fehlenden Erhöhung der Nullsystemspannung $U_0$ als fehlerfrei angesehen wird. Zuvor wird in Schritt 23a ein Zeitgeber für die Verzögerungszeit $T_{TD}$ deaktiviert.

Wenn hingegen in Schritt 23 festgestellt wird, dass sich die Erdungseinrichtung 13 in einem aktivierten Zustand befindet, so wird in Schritt 24 der Status des Zeitgebers für die Verzögerungszeit $T_{TD}$ überprüft. Ist dieser noch inaktiv, d.h. der Hinweis auf einen Erdfehler ist erstmalig erfolgt, so wird in Schritt 24a der Zeitgeber bei einem Wert von t=0 gestartet und damit der Ablauf der Verzögerungszeit $T_{TD}$ eingeleitet. Außerdem wird in einem Schritt 24b wie oben bereits erläutert der Nullsystemspannungs-Schwellenwert $U_{0P}$ auf einen reduzierten Wert $U'_{0P}$ gesetzt.

Ergibt die Prüfung des Zeitgebers in Schritt 24 hingegen, dass dieser bereits aktiv ist, d.h. der Ablauf der Verzögerungszeit $T_{TD}$ wurde zuvor bereits gestartet, so wird das Verfahren direkt bei Schritt 25 fortgesetzt.

In Schritt 25 werden die Erdfehlerkriterien auf das Vorliegen eines Erdfehlers geprüft. Konkret wird also einerseits die Admittanzgröße in Form der Nullsystem-Konduktanz $G_0$ mit dem Admittanz-Schwellenwert $G_{0P}$ verglichen.

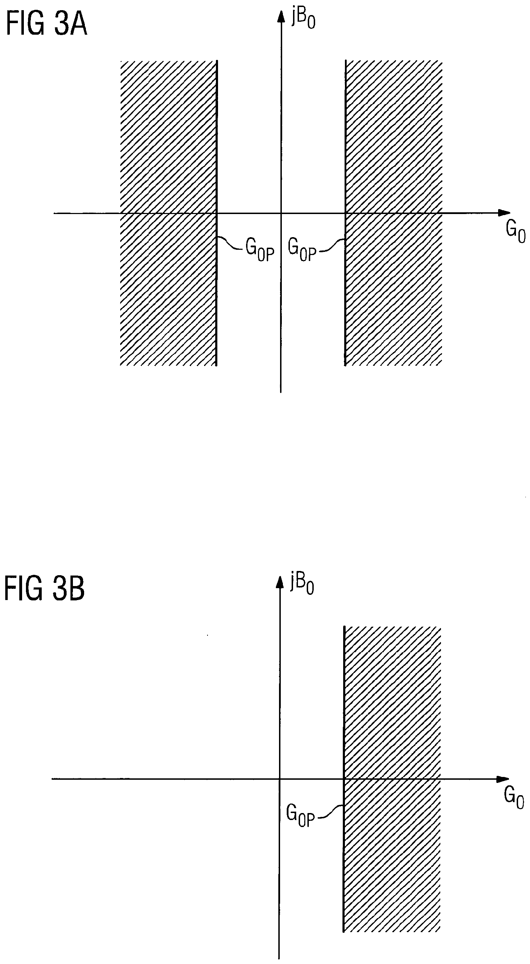

Der Admittanz-Schwellenwert $G_{0P}$ besteht üblicherweise nicht aus einem einzigen Wert, sondern aus einer Kennlinie oder mehreren Kennlinien, wie sie beispielhaft in Figuren 3A und 3B gezeigt sind. Dabei zeigt Figur 3A ein Admittanz-Diagramm, in dem die Nullsystem-Konduktanz $G_0$ (der Realteil der Admittanz) und die Nullsystem-Suszeptanz $jB_0$ (der Imaginärteil der Admittanz) in der komplexen Zahlenebene aufgetragen sind. Außerdem sind Kennlinien eingezeichnet, die den Admittanz-Schwellenwert $G_0$ in positiver und negativer Richtung festlegen. Damit stellt Figur 3A den Admittanz-Schwellenwert für eine ungerichtete Erdfehlererkennung dar, d.h. der Fehler wird unabhängig von der Fehlerrichtung erkannt und angezeigt. In diesem Fall bedeutet eine Überschreitung des Admittanz-Schwellenwertes durch die Admittanzgröße $G_0$ entweder eine Überschreitung des positiven Schwellenwertes $G_{0P}$ oder eine Unterschreitung des negativen Schwellenwertes $-G_{0P}$. Im Unterschied dazu stellt Figur 3B die Lage des Admittanz-Schwellenwertes für eine gerichtete Erdfehlererkennung dar, d.h. der Fehler wird nur in einer Richtung (Vorwärtsrichtung) vom Schutzgerät aus gesehen erkannt. Hier wird eine Überschreitung des Admittanz-Schwellenwertes durch die Admittanzgröße $G_0$ lediglich durch eine Überschreitung des positiven Schwellenwertes $G_{0P}$ bewirkt.

Andererseits wird zur Erkennung eines Erdfehlers die Nullsystemspannung $U_0$ mit dem reduzierten Nullsystemspannungs-Schwellenwert $U'_{0P}$ verglichen. Überschreiten sowohl die Admittanzgröße $G_0$ als auch die Nullsystemspannung $U_0$ die jeweiligen Schwellenwerte, so wird als Ergebnis der Prüfung in Schritt 25 ein Anregesignal erzeugt, das einen Hinweis auf einen vorliegenden Erdfehler angibt.

Da wie zuvor erwähnt aus Stabilitätsgründen vor einer endgültigen Fehlerentscheidung der Ablauf der Verzögerungszeit $T_{TD}$ abgewartet werden soll, wird in Schritt 26 daraufhin der Stand des Zeitgebers der Verzögerungszeit $T_{TD}$ überprüft.

Ist die seit Aktivierung des Zeitgebers abgelaufene Zeitdauer t kleiner als die Verzögerungszeit $T_{TD}$, so wird in Schritt 26a der Zähler des Zeitgebers der Verzögerungszeit $T_{TD}$ inkrementell erhöht und das Verfahren erneut bei Schritt 21 fortgesetzt.

Ergibt die Prüfung in Schritt 26 hingegen, dass die Verzögerung $T_{TD}$ abgelaufen ist, so wird das Verfahren bei Schritt 27 fortgesetzt, in dem die letzte anstehende Entscheidung bezüglich des Vorliegens eines Erdfehlers gemäß Schritt 25 umgesetzt wird. In Schritt 27 wird somit bei Erkennung des Vorliegens eines Erdfehlers ein Fehlersignal erzeugt. Dieses Fehlersignal wird von demjenigen Schutzgerät 16a-c (vgl. Figur 1) abgegeben, bezüglich dessen Leitung der Fehler erkannt worden ist. Bei dem Beispiel aus Figur 1 wird das Fehlersignal folglich von dem Schutzgerät 16b bezüglich des Erdfehlers auf der Abzweigleitung 14b abgegeben. Das Fehlersignal kann entweder lediglich als Warnung für den Betreiber des Energieversorgungsnetzes 10 verwendet werden, die ihn auf das Vorliegen des Erdfehlers bezüglich der bestimmten Abzweigleitung hinweist, so dass bei nächster Gelegenheit der Fehler beseitigt werden kann. Das Fehlersignal kann aber auch die Erzeugung eines Ausschaltsignals bzw. Trip-Signals bewirken, das von dem Schutzgerät 16b an die Schalteinrichtung 15b abgegeben wird und diese zum Öffnen ihrer Schaltkontakte veranlasst, um die fehlerbehaftete Abzweigleitung 14b vom restlichen Energieversorgungsnetz 10 abzutrennen und einen reibungslosen Weiterbetrieb des fehlerfreien Teils des Energieversorgungsnetzes 10 zu ermöglichen.

In Schritt 28 schließlich wird der Nullsystemspannungs-Schwellenwert vom seinem reduzierten Wert $U'_{0P}$ wieder auf den ursprünglichen Wert $U_{0P}$ angehoben. Danach beginnt das Verfahren mit Schritt 21 erneut.

Das vorstehend beschriebene Verfahren wird üblicherweise von einem Schutzgerät mittels einer Messeinrichtung und einer Fehlererkennungseinrichtung unter Abarbeitung einer Gerätesoftware durchgeführt. Die beschriebenen Schritte 20-28 stellen in diesem Fall Programmschritte der Gerätesoftware dar. Alternativ können die einzelnen Schritte aber beispielsweise auch durch elektronische Elemente des Schutzgerätes realisiert werden.

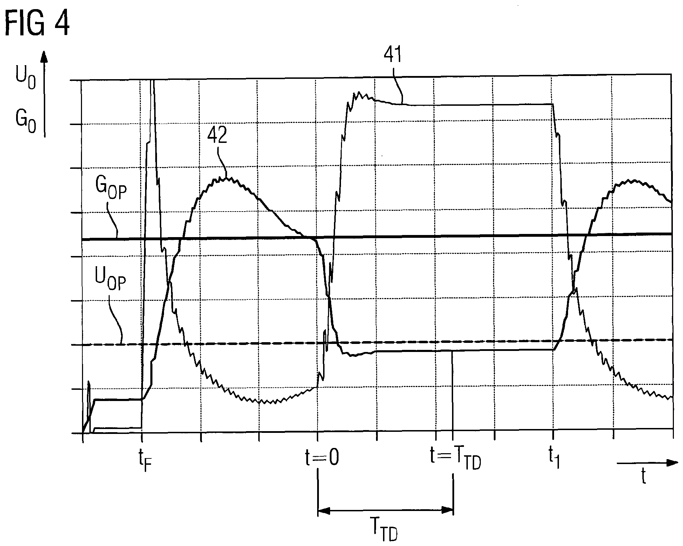

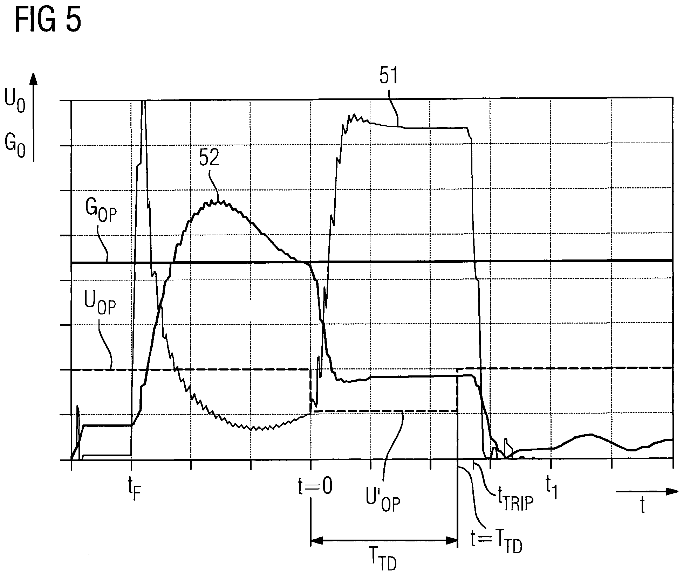

Die Figuren 4 und 5 zeigen schließlich in einem jeweiligen Diagramm den zeitlichen Verlauf der Erdfehlerkriterien Nullsystemspannung $U_0$ und Admittanzgröße in Form des Nullsystem-Leitwertes $G_0$ beispielhaft für den Fall eines hochohmigen Erdfehlers mit einem Fehlerwiderstand von 5kΩ. Dabei zeigt Figur 4 die Situation ohne adaptive Anpassung des Nullsystemspanungs-Schwellenwertes $U_{0P}$, während Figur 5 die Situation mit adaptiver Anpassung des Nullsystemspanungs-Schwellenwertes $U_{0P}$ bzw. $U'_{0P}$ darstellt.

In Figur 4 erkennt man in schematischer Darstellung einen zeitlichen Verlauf 41 der Admittanzgröße $G_0$ und einen zeitlichen Verlauf 42 der Nullsystemspannung $U_0$. Außerdem sind in Figur 4 die jeweiligen Schwellenwerte $G_{0P}$ und $U_{0P}$ eingetragen. Zum Zeitpunkt $t=t_F$ tritt der Erdfehler ein. Man erkennt deutlich den hieraus resultierenden Anstieg sowohl der Nullsystemspannung $U_0$ als auch der Admittanzgröße $G_0$. Während die Admittanzgröße $G_0$ nach einem kurzzeitigen Umladevorgang, während dem Umladeströme in der Induktivität L (siehe Figur 1) fließen, aufgrund des danach fließenden geringen Stroms wieder unter den Admittanz-Schwellenwert $G_{0P}$ absinkt, bleibt die Nullsystemspannung $U_0$ zunächst auf einem im Vergleich zum Nullsystemspannungs-Schwellenwert $U_{0P}$ signifikant erhöhten Level.

Zum Zeitpunkt $t=0$ entscheidet die Steuereinrichtung 13b der Erdungseinrichtung 13, dass die erhöhte Nullsystemspannung $U_0$ auf das Vorliegen eines Erdfehlers hindeuten könnte und schaltet mittels der Schalteinrichtung 13a den ohmschen Widerstand R parallel zur Induktivität L, wodurch der Sternpunkt des Energieversorgungsnetzes 10 mit Erde verbunden wird. Gleichzeitig wird der Ablauf der Verzögerungszeit $T_{TD}$ gestartet.

Das Aktivieren der Erdungseinrichtung führt durch die Erdung des Sternpunkts einerseits zu einem deutlichen Anstieg des durch die Fehlerstelle fließenden Stroms, was sich am signifikanten Anstieg der Admittanzgröße $G_0$ zeigt. Andererseits bewirkt die Erdung des Sternpunktes aber ein deutliches Absinken der Nullsystemspannung $U_0$. Dieser Effekt tritt umso stärker auf, je höher der Fehlerwiderstand ist. Im Beispiel der Figur 4 ist der Fehlerwiderstand derart hoch, dass die Nullsystemspannung $U_0$ unter den Nullsystemspannungs-Schwellenwert $U_{0P}$ sinkt, wodurch bei der Überprüfung der Erdfehlerkriterien am Ende der Verzögerungszeit $T_{TD}$ zum Zeitpunkt $t=T_{TD}$ trotz deutlich erhöhter Admittanzgröße fälschlicherweise kein Erdfehler erkannt wird. Folglich wird zum Zeitpunkt $t=T_{TD}$ kein Fehlersignal erzeugt. Zum Zeitpunkt $t=t_1$ schließlich wird die Erdungseinrichtung wieder deaktiviert, beispielsweise weil eine voreingestellte Zykluszeit der Erdungseinrichtung abgelaufen ist. Man erkennt den erneuten deutlichen Anstieg der Nullsystemspannung $U_0$, bei weiterhin anstehendem Erdfehler wiederholt sich das beschriebene Verhalten entsprechend.

In Figur 5 erkennt man in schematischer Darstellung einen zeitlichen Verlauf 51 der Admittanzgröße $G_0$ und einen zeitlichen Verlauf 52 der Nullsystemspannung $U_0$. Außerdem sind auch in Figur 5 die jeweiligen Schwellenwerte $G_{0P}$ und $U_{0P}$ eingetragen. Bis zum Zeitpunkt $t=t_0$ entspricht das Verhalten der Verläufe der Nullsystemspannung $U_0$ und der Admittanzgröße $G_0$ dem zu Figur 4 erläuterten Verhalten. Zum Zeitpunkt $t=t_0$ wird jedoch aufgrund der aktivierten Erdungseinrichtung der Nullsystemspanungs-Schwellenwert $U_{0P}$ auf den Wert $U'_{0P}$ abgesenkt (vergleiche Schritt 24b der Figur 2). Wie dem Diagramm nach dem Zeitpunkt $t=0$ entnommen werden kann, verläuft durch die Absenkung des Nullsystemspannungs-Schwellenwertes die Nullsystemspannung $U_0$ nunmehr dauerhaft oberhalb des abgesenkten Schwellenwertes $U'_{0P}$, so dass nach Ablauf der Verzögerungszeit zum Zeitpunkt $t=T_{TD}$ sowohl die Nullsystemspannung als auch die Admittanzgröße oberhalb ihrer jeweiligen Schwellenwerte liegen und daher ein Fehlersignal erzeugt wird. Im Beispiel der Figur 5 wird dieses Fehlersignal zur Erzeugung eines Ausschaltbefehles verwendet, der an die betreffende Schalteinrichtung übermittelt wird. Zum Zeitpunkt $t=t_{TRIP}$ befindet sich die fragliche Schalteinrichtung in einem geöffneten Zustand, wodurch die fehlerbehaftete Leitung ausgeschaltet ist. Man erkennt, dass sowohl die Nullsystemspannung $U_0$ als auch die Admittanzgröße $G_0$ unterhalb ihrer Schwellenwerte liegen. Im Folgenden kann der Betreiber eine Beseitigung des Fehlers an der fehlerbehafteten Leitung einleiten.

Wie man bei Vergleich der Figuren 4 und 5 erkennen kann, wird durch das beschriebene Verfahren zur Erdfehlererkennung auch bei hochohmigen Fehlern eine zuverlässige Erkennung des Vorliegens eines Erdfehlers gewährleistet.

## Patentansprüche

1. Verfahren zum Erkennen eines Erdfehlers in einem elektrischen Energieversorgungsnetz (10) mit kompensiertem Sternpunkt, bei dem

- an zumindest einer Messstelle des Energieversorgungsnetzes (10) Messwerte erfasst werden, die einen Zustand des Energieversorgungsnetzes (10) charakterisieren;
- aus den Messwerten eine Nullsystemspannung und eine Admittanzgröße ermittelt werden; und
- die Nullsystemspannung und die Admittanzgröße zur Erkennung des Erdfehlers in dem Energieversorgungsnetz (10) herangezogen werden;

**dadurch gekennzeichnet, dass**

- beim Vorliegen von Messwerten, die auf einen Erdfehler in dem Energieversorgungsnetz (10) hindeuten, der Sternpunkt des Energieversorgungsnetzes (10) durch Zuschalten einer Erdungseinrichtung (13) temporär mit Erde verbunden wird; und
- ein Erdfehler in dem Energieversorgungsnetz (10) erkannt wird, wenn während der zugeschalteten Erdungseinrichtung (13) sowohl die Nullsystemspannung einen vorgegebenen Nullsystemspannungs-Schwellenwert als auch die Admittanzgröße einen vorgegebenen Admittanz-Schwellenwert überschreiten, wobei
- das Zuschalten der Erdungseinrichtung (13) eine Reduzierung des Nullsystemspannungs-Schwellenwertes bewirkt.

2. Verfahren nach Anspruch 1,
**dadurch gekennzeichnet, dass**

- die Reduzierung des Nullsystemspannungs-Schwellenwertes nach Ablauf einer vorgegebenen Verzögerungszeit zurückgenommen wird.

3. Verfahren nach Anspruch 1 oder 2,
**dadurch gekennzeichnet, dass**

- die Reduzierung des Nullsystemspannungs-Schwellenwertes gemäß der Gleichung

$$U'_{0P} = k_R \cdot U_{0P}$$

erfolgt, mit

$U'_{0P}$: Nullspanungs-Schwellenwert nach der Reduzierung;
$U_{0P}$: Nullspannungs-Schwellenwert; und
$k_R$: einstellbarer Reduzierungsfaktor.

4. Verfahren nach einem der vorangehenden Ansprüche,
**dadurch gekennzeichnet, dass**

- als Admittanzgröße eine Nullsystem-Admittanz oder der Realteil der Nullsystem-Admittanz verwendet wird.

5. Verfahren nach einem der vorangehenden Ansprüche,
**dadurch gekennzeichnet, dass**

- zur Untersuchung, ob die Messwerte auf einen Erdfehler in dem Energieversorgungsnetz (10) hindeuten, geprüft wird, ob die Nullsystemspannung einen erhöhten Wert annimmt.

**6.** Verfahren nach einem der vorangehenden Ansprüche,
**dadurch gekennzeichnet, dass**

- bei Erkennung eines Erdfehlers ein den Fehler angebendes Fehlersignal erzeugt wird.

**7.** Verfahren nach Anspruch 6,
**dadurch gekennzeichnet, dass**

- das Fehlersignal ein Ausschalten einer Schalteinrichtung (15a-c) bewirkt.

**8.** Verfahren nach einem der vorangehenden Ansprüche,
**dadurch gekennzeichnet, dass**

- das Verfahren für mehrere Leitungen (14a-c) in dem elektrischen Energieversorgungsnetz (10) durchgeführt wird, wobei die Nullsystemspannung für das Energieversorgungsnetz (10) insgesamt bestimmt wird und die Admittanzgröße für jede Leitung (14a-c) separat ermittelt wird; und
- diejenige Leitung (14a-c) als von dem Erdfehler betroffen erkannt wird, für die die Admittanzgröße den vorgegebenen Admittanz-Schwellenwert überschreitet.

**9.** Elektrisches Schutzgerät (16a-c) zur Erkennung von Erdfehlern in Energieversorgungsnetzen (10) mit kompensiertem Sternpunkt mit

- einer Messeinrichtung zur Erfassung von Messwerten, die einen Zustand des Energieversorgungsnetzes (10) charakterisieren und zur Ermittlung einer Nullsystemspannung und einer Admittanzgröße aus dem Messwerten; und
- einer Fehlererkennungseinrichtung, die dazu eingerichtet ist, eine Erkennung eines Erdfehlers unter Heranziehung der Nullsystemspannung und der Admittanzgröße durchzuführen,

**dadurch gekennzeichnet, dass**

- das Schutzgerät (16a-c) dazu eingerichtet ist, mit einer Erdungseinrichtung (13) zusammenzuwirken, die beim Vorliegen von Messwerten, die auf einen Erdfehler in dem Energieversorgungsnetz (10) hindeuten, den Sternpunkt des Energieversorgungsnetzes (10) mit Erde verbindet; und
- die Fehlererkennungseinrichtung dazu eingerichtet ist, einen Erdfehler in dem Energieversorgungsnetz (10) zu erkennen, wenn während der zugeschalteten Erdungseinrichtung (13) sowohl die Nullsystemspannung einen vorgegebenen Nullsystemspannungs-Schwellenwert als auch die Admittanzgröße einen vorgegebenen Admittanz-Schwellenwert überschreiten, wobei
- die Fehlererkennungseinrichtung zudem dazu eingerichtet ist, mit dem Zuschalten der Erdungseinrichtung (13) eine Reduzierung des Nullsystemspannungs-Schwellenwertes vorzunehmen.

**10.** Schutzsystem zur Erkennung von Erdfehlern in Energieversorgungsnetzen (10) mit kompensiertem Sternpunkt mit

- einer Erdungseinrichtung (13), die beim Vorliegen von einen Zustand des Energieversorgungsnetzes charakterisierenden Messwerten, die auf einen Erdfehler in dem Energieversorgungsnetz (10) hindeuten, den Sternpunkt des Energieversorgungsnetzes mit Erde verbindet, und
- mindestens einem gemäß Anspruch 9 ausgebildeten elektrischen Schutzgerät (16a-c).

**Claims**

**1.** Method for identifying an earth fault in an electrical energy supply network (10) having a compensated star point, in which

- measurement values are detected at at least one measurement point of the energy supply network (10), which measurement values characterize a state of the energy supply network (10);
- a zero phase-sequence system voltage and an admittance quantity are ascertained from the measurement values; and
- the zero phase-sequence system voltage and the admittance quantity are used to identify the earth fault in the energy supply network (10);

**characterized in that**

- in the presence of measurement values that suggest an earth fault in the energy supply network (10), the star point of the energy supply network (10) is temporarily connected to earth through connection of an earthing device (13); and
- an earth fault in the energy supply network (10) is identified when, while the earthing device (13) is connected, both the zero phase-sequence system voltage exceeds a prescribed zero phase-sequence system voltage threshold value and the admittance quantity exceeds a prescribed admittance threshold value, wherein
- the connection of the earthing device (13) causes a reduction in the zero phase-sequence system voltage threshold value.

2. Method according to Claim 1,
   **characterized in that**

   - the reduction in the zero phase-sequence system voltage threshold value is cancelled after a prescribed delay time has elapsed.

3. Method according to Claim 1 or 2,
   **characterized in that**

   - the reduction in the zero phase-sequence system voltage threshold value is carried out according to the equation

$$U'_{0P} = k_R \cdot U_{0P}$$

   where

   $U'_{0P}$: zero phase-sequence voltage threshold value after the reduction;
   $U_{0P}$: zero phase-sequence voltage threshold value; and
   $k_R$: adjustable reduction factor.

4. Method according to one of the preceding claims, **characterized in that**

   - a zero phase-sequence system admittance or the real part of the zero phase-sequence system admittance is used as the admittance quantity.

5. Method according to one of the preceding claims, **characterized in that**

   - to examine whether the measurement values suggest an earth fault in the energy supply network (10), a check is carried out to determine whether the zero phase-sequence system voltage assumes an increased value.

6. Method according to one of the preceding claims, **characterized in that**

   - upon identification of an earth fault, a fault signal that indicates the fault is generated.

7. Method according to Claim 6,
   **characterized in that**

   - the fault signal causes a switching device (15a-c) to switch off.

8. Method according to one of the preceding claims, **characterized in that**

   - the method is carried out for a plurality of lines (14a-c) in the electrical energy supply network (10), wherein the zero phase-sequence system voltage is determined for the energy supply network (10) overall and the admittance quantity is ascertained for each line (14a-c) separately; and

- that line (14a-c) for which the admittance quantity exceeds the prescribed admittance threshold value is identified as affected by the earth fault.

9. Electrical protection unit (16a-c) for identifying earth faults in energy supply networks (10) having a compensated star point having

- a measurement device for detecting measurement values that characterize a state of the energy supply network (10) and for ascertaining a zero phase-sequence system voltage and an admittance quantity from the measurement values; and
- a fault identification device, which is configured to identify an earth fault using the zero phase-sequence system voltage and the admittance quantity,

**characterized in that**

- the protection unit (16a-c) is configured to interact with an earthing device (13), which, in the presence of measurement values that suggest an earth fault in the energy supply network (10), connects the star point of the energy supply network (10) to earth; and
- the fault identification device is configured to identify an earth fault in the energy supply network (10) when, while the earthing device (13) is connected, both the zero phase-sequence system voltage exceeds a prescribed zero phase-sequence system voltage threshold value and the admittance quantity exceeds a prescribed admittance threshold value, wherein
- the fault identification device is also configured to perform a reduction in the zero phase-sequence system voltage threshold value using the connection of the earthing device (13).

10. Protection system for identifying earth faults in energy supply networks (10) having a compensated star point having

- an earthing device (13), which, in the presence of measurement values that characterize a state of the energy supply network and suggest an earth fault in the energy supply network (10), connects the star point of the energy supply network to earth, and
- at least one electrical protection unit (16a-c) formed according to Claim 9.

## Revendications

1. Procédé de détection d'un défaut à la terre dans un réseau (10) d'alimentation en énergie électrique à point neutre compensé, dans lequel

- on relève, en au moins un point de mesure du réseau (10) d'alimentation en énergie, des valeurs de mesure, qui caractérisent un état du réseau (10) d'alimentation en énergie;
- à partir des valeurs de mesure, on détermine une tension de système homopolaire et une grandeur d'admittance et
- on tire parti de la tension de système homopolaire et de la grandeur d'admittance pour détecter le défaut à la terre dans le réseau (10) d'alimentation en énergie;

**caractérisé en ce que**

- en présence de valeurs de mesure, qui donnent à penser qu'il y a un défaut à la terre dans le réseau (10) d'alimentation en énergie, on relie le point neutre du réseau (10) d'alimentation en énergie temporairement à la terre, par mise en circuit d'un dispositif (13) de mise à la terre et
- on détecte un défaut à la terre dans le réseau (10) d'alimentation en énergie si, pendant que le dispositif (13) de mise à la terre est mis en circuit, à la fois la tension de système homopolaire dépasse une valeur de seuil de tension de système homopolaire donnée à l'avance et la grandeur d'admittance une valeur de seuil d'admittance donnée à l'avance, dans lequel
- la mise en circuit du dispositif (13) de mise à la terre provoque une réduction de la valeur de seuil de la tension de système homopolaire.

2. Procédé suivant la revendication 1,
**caractérisé en ce que**

- on revient sur la réduction de la valeur de seuil de la tension de système homopolaire après écoulement d'un temps de retard donné à l'avance.

**3.** Procédé suivant la revendication 1 ou 2,
**caractérisé en ce que**

- la réduction de la valeur de seuil de la tension de système homopolaire s'effectue suivant l'équation

$$U'_{OP} = k_R \ U_{OP}$$

avec

U'$_{OP}$ : valeur de seuil de tension homopolaire après la réduction;
U$_{OP}$ : valeur de seuil de tension homopolaire et
K$_R$ : facteur de réduction réglable.

**4.** Procédé suivant l'une des revendications précédentes, **caractérisé en ce que**

- on utilise, comme grandeur d'admittance, une admittance de système homopolaire ou la partie réelle de l'admittance du système homopolaire.

**5.** Procédé suivant l'une des revendications précédentes, **caractérisé en ce que**

- pour rechercher si les valeurs de mesure donnent à penser qu'il y a un défaut à la terre dans le réseau (10) d'alimentation en énergie, on contrôle si la tension de système homopolaire augmente de valeur.

**6.** Procédé suivant l'une des revendications précédentes, **caractérisé en ce que**

- à la détection d'un défaut à la terre, on produit un signal de défaut indiquant le défaut.

**7.** Procédé suivant la revendication 6,
**caractérisé en ce que**

- le signal de défaut provoque une ouverture d'un dispositif (15a-c) d'interruption.

**8.** Procédé suivant l'une des revendications précédentes, **caractérisé en ce que**

- on effectue le procédé pour plusieurs lignes (14a-c) du réseau (10) d'alimentation en énergie électrique, dans lequel on détermine dans l'ensemble la tension de système homopolaire pour le réseau (10) d'alimentation en énergie et on détermine séparément la grandeur d'admittance pour chaque ligne (14a-c) et
- on détecte la ligne (14a-c) comme concernée par le défaut à la terre, pour laquelle la grandeur d'admittance dépasse la valeur de seuil d'admittance donnée à l'avance.

**9.** Appareil (16a-c) électrique de protection pour détecter des défauts à la terre dans des réseaux (10) d'alimentation en énergie à point neutre compensé comprenant

- un dispositif de mesure pour relever des valeurs de mesure, qui caractérisent un état du réseau (10) d'alimentation en énergie et pour déterminer une tension de système homopolaire et une grandeur d'admittance à partir des valeurs de mesure et
- un dispositif de détection de défaut conçu pour effectuer une détection d'un défaut à la terre, en tirant parti de la tension de système homopolaire et de la grandeur d'admittance, **caractérisé en ce que**
- l'appareil (16a-c) de protection est conçu pour coopérer avec un dispositif (13) de mise à la terre, qui, en présence de valeurs de mesure, qui donnent à penser qu'il y a un défaut à la terre dans le réseau (10) d'alimentation en énergie, relie à la terre le point neutre du réseau (10) d'alimentation en énergie et
- le dispositif de détection de défaut est conçu pour détecter un défaut à la terre dans le réseau (10) d'alimentation en énergie si, pendant que le dispositif (13) de mise à la terre est en circuit, tant la tension de système homopolaire dépasse une valeur de seuil de tension de système homopolaire donnée à l'avance qu'également la grandeur d'admittance dépasse une valeur de seuil d'admittance donnée à l'avance, dans lequel
- le dispositif de détection de défaut est conçu, en outre, pour effectuer, avec la mise en circuit du dispositif (13) de mise à la terre, une réduction de la valeur de seuil de la tension de système homopolaire.

**10.** Système de protection pour détecter des défauts à la terre dans des réseaux (10) d'alimentation en énergie à point neutre compensé comprenant

- un dispositif (13) de mise à la terre, qui, en présence de valeurs de mesure caractérisant un état du réseau d'alimentation en énergie, qui donnent à penser qu'il y a un défaut à la terre dans le réseau (10) d'alimentation en énergie, relie à la terre le point neutre du réseau d'alimentation en énergie et
- au moins un appareil (16a-c) électrique de protection constitué suivant la revendication 9.

FIG 1

## FIG 2

$$U_{0P},\ G_{0P},\ k_R \quad \sim 20$$

```
                        ┌──────────────┐
                        │  U0P, G0P, kR │ ─── 20
                        └──────┬───────┘
                               │
                        ┌──────▼───────┐
                        │              │ ─── 21
                        └──────┬───────┘
                               │
                        ┌──────▼───────┐
                        │              │ ─── 22
                        └──────┬───────┘
                               │
        23a                    │    23
     ┌────────┐          ◇─────┴─────◇
  ◄──│        │◄─────────◇           ◇
     └────────┘          ◇───────────◇
                               │
                               │    24
                         ◇─────┴─────◇      ┌────────┐
                         ◇           ◇─────►│        │ ── 24a
                         ◇───────────◇      └───┬────┘
                               ▲              ┌─▼──────┐
                               └──────────────│        │ ── 24b
                               │              └────────┘
                        ┌──────▼───────┐
                        │              │ ─── 25
                        └──────┬───────┘
        26a                    │    26
     ┌────────┐          ◇─────┴─────◇
  ◄──│        │◄─────────◇  t > TTD ? ◇
     └────────┘          ◇───────────◇
                               │
                        ┌──────▼───────┐
                        │              │ ─── 27
                        └──────┬───────┘
                               │
                        ┌──────▼───────┐
                        │              │ ─── 28
                        └──────────────┘
```

FIG 3A

$jB_0$

$G_0$

$G_{0P}$    $G_{0P}$

FIG 3B

$jB_0$

$G_0$

$G_{0P}$

## FIG 4

# FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0122104 A1
- WO 2004003578 A1

**In der Beschreibung aufgeführte Nicht-Patentliteratur**

- A Fuzzy Logic-Based Algorithm for Dicrimination of Damaged Line During Intermittent Earth Faults. **VON K. MUSIEROWICZ ; J. LORENC ; Z. MARCINKOWSKI ; A. KWAPISZ.** Power Tech. IEEE, 27. Juni 2005, 1-5